Europäisches Patentamt

European Patent Office

Office européen des brevets

(19)

(11) Numéro de publication: **0 072 727**
**B1**

(12) # FASCICULE DE BREVET EUROPEEN

(45) Date de publication du fascicule du brevet:
**19.03.86**

(51) Int. Cl.⁴: **H 01 R 43/00**

(21) Numéro de dépôt: **82401427.8**

(22) Date de dépôt: **30.07.82**

(54) Ensemble de contacts à souder et procédé de mise en place de contacts sur des substrats à l'aide d'un tel ensemble.

(30) Priorité: **14.08.81 FR 8115964**

(43) Date de publication de la demande:
**23.02.83 Bulletin 83/8**

(45) Mention de la délivrance du brevet:
**19.03.86 Bulletin 86/12**

(84) Etats contractants désignés:
**BE CH DE GB IT LI**

(56) Documents cités:
**FR - A - 2 352 415**
**FR - A - 2 372 526**

(73) Titulaire: **COMATEL Société Anonyme:, 40, rue de Montlhéry Silic 148, F-93523 Rungis Cedex (FR)**

(72) Inventeur: **Cabaud, Aimé, 28, rue de Villacoublay, F-78140 Velizy (FR)**

(74) Mandataire: **Boivin, Claude, 9, rue Edouard-Charton, F-78000 Versailles (FR)**

LIBER, STOCKHOLM 1986

## Description

La présente invention concerne les contacts à souder destinés à réaliser des connexions en électronique et notamment à être montés sur des circuits hybrides ou sur des circuits imprimés. Ces contacts à souder présentent à l'une deleurs extrémités une pince dans laquelle on insère par exemple un bord de circuit hybride; l'autre extrémité du contact est insérée dans un circuit imprimé ou soudée à un conducteur.

On connaît en particulier des ensembles de contacts à souder qui se presentent sous la forme d'une bande dans laquelle les contacts sont formés et sont reliés entre eux par des bandelettes à leurs extrémités. Des exemples de contacts de ce genre sont décrits notamment dans les documents FR-A-2 352 415 et FR-A-2 372 526.

Lors de la mise en place des contacts, on découpe dans la bande le nombre désiré de contacts, cette découpe étant effectuée soit manuellement, soit de préférence mécaniquement.

La présente invention a pour objet un perfectionnement apporté aux ensembles de contacts à souder, qui permet de diminuer notablement le prix de revient de ces contacts ainsi que la durée nécessaire à l'insertion d'une série de contacts.

L'ensemble de contacts selon l'invention est caractérisé en ce que les contacts sont alternés et disposés têtebeche et en ce que la pince de chaque contact comporte uniquement deux lamelles, l'une de ces lamelles étant pliée, alors que l'autre est plane et attenante à la bandelette.

Grâce à cette disposition, les contacts peuvent être beaucoup plus serrés dans la bande et, dans une même opération, on forme pratiquement deux fois plus de contacts; il y a notablement moins de matière perdue. On peut inserer simultanément une plaquette de circuit hybride ou de circuit imprimé à chacun des bords de la bande; on double ainsi la cadence d'insertion.

La présente invention a également pour objet un procédé de mise en place de contacts sur des substrats à l'aide de cet ensemble de contacts, qui est caractérisé en ce qu'on sépare de chaque bandelette les lamelles planes qui lui sont attenantes, de façon à former deux sous-ensembles de contacts comportant chacun une pince à son extrémité libre, qu'on écarte ces deux sous-ensembles pour les amener dans des plans différents, qu'on insère simultanément des substrats dans les pinces des contacts des deux sous-ensembles, et qu'on retire des contacts insérés la bandelette.

On a décrit ci-après à titre d'exemple non limitatif, un mode de realisation de l'ensemble de contacts à souder selon l,invention avec référence au dessin annexé dans lequel:

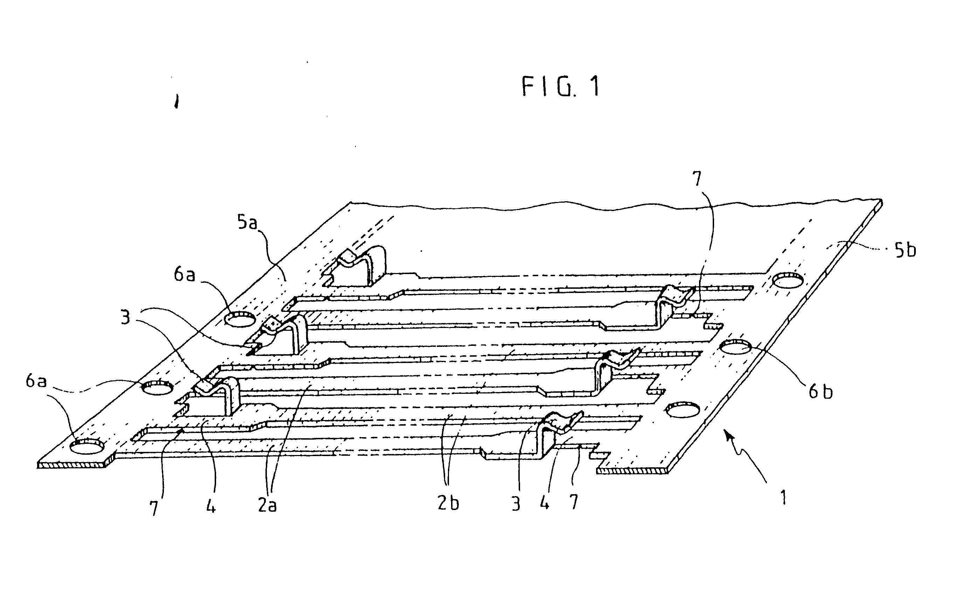

La Figure 1 est une vue en perspective d'une partie de cet ensemble;

La Figure 2 est une vue semblable à la Figure 1 et montre séparées les deux séries de contacts.

Au dessin, on voit une bande 1 dans laquelle sont formés des contacts à souder 2a et 2b. Chacun de ces contacts comprend un corps allongé terminé à l'une de ses extrémités par une pince formée d'une lamelle pliée 3 et d'une lamelle plane 4 adjacente à la première. Les contacts 2a et 2b sont alternés et disposés têtebêche dans la bande 1, c'est-à-dire que la pince 3-4 d'un contact 2a se trouve entre les extrémités non munies de pinces de deux contacts 2b et qu'inversement, la pince 3-4 d'un contact 2b se trouve entre les extrémités non munies de pinces de deux contacts 2a.

Les contacts 2a et 2b sont réunis les uns aux autres par des bandelettes 5a et 5b. La bandelette 5a est munie de trous 6a dans l'axe des contacts 2a; de maniére analogue, la bandelette 5b est munie de trous 6b dans l'axe des contacts 2b. Ces trous 6a et 6b ont notamment pour but de permettre l'avance de la bande 1 d'une part, lors de la fabrication des contacts et d'autre part, lors de la mise en place de ces contacts sur une plaquette formant support pour un circuit-hybride ou sur une plaquette de circuit imprimé.

Une amorce de rupture 7 est prévue entre l'extrémité de la lame 4 d'une pince et la bandelette 5a ou 5b adjacente.

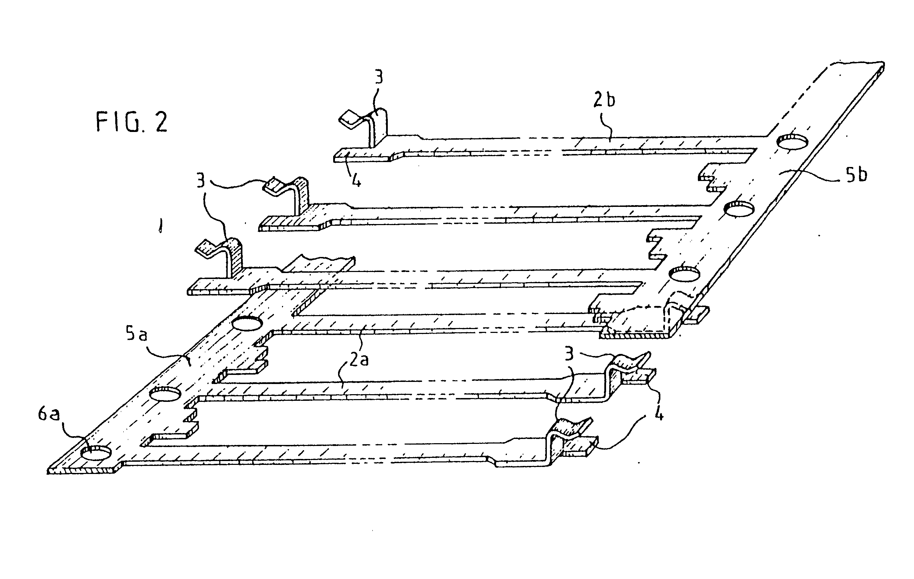

Pour utiliser cet ensemble, on sépare dans la région des amorces de rupture 7, à l'aide d'une lame de coupe, d'une part de la bandelette 5b les pièces 3-4 des contacts 2a qui restent solidaires de la bandelette 5a, et d'autre part de cette bandelette 5a, les pièces 3-4 des contacts 2b qui restent solidaires de la bandelette 5b (Figure 2). On améne les contacts 2a et 2b dans des plans différents et on insere simultanément dans leurs pinces 3-4 des substrats pour circuit hybride ou des plaquettes de circuit imprimé. Il ne reste plus qu'à retirer des contacts insérés la bandelette 5a ou 5b qui les relie.

## Revendications:

1. Ensemble de contacts à souder munis d'une pince à l'une de leurs extrémités constitué par une bande (1) dans laguelle les contacts (2a et 2b) sont formés et reliés entre eux par des bandelettes (5a et 5b), caractérisé en ce que les contacts (2a et 2b) sont alternés et disposés têtebêche et en ce que la pince de chaque contact comporte uniquement deux lamelles (3 et 4) la lamelle (3) étant pliée alors que la lamelle (4) est plane et attenante à la bandelette (5a ou 5b).

2. Ensemble de contacts selon la revendication 1, caractétisé en ce qu'une amorce de rupture (7) est prévue entre l'extrémité de la pince et la bandelette (5a ou 5b) adjacente.

3. Procédé de mise en place de contacts sur des substrats à l'aide de l'ensemble de contacts selon la revendication 1 ou 2, caractérisé en ce qu'on sépare de chaque bandelette (5a ou 5b) les lamelles planes (4) qui lui sont attenantes, de façon à former deux sous-ensembles de contacts comportant chacun une pince à son extrémité libre, qu'on écarte ces deux sous-ensembles pour les amener dans des plans différents, qu'on insère simultanément des substrats dans les pinces des contacts des deux sous-ensembles, et qu'on retire des contacts insérés la bandelette (5a ou 5b).

**Patentansprüche.**

1. Baueinheit aus Lötkontakten, die an einem ihrer Enden eine Klemme aufweisen, bestehend aus einem Streifen (1), in welchem die Kontakte (2a und 2b) ausgebildet und durch Handleisten (5a und 5b) miteinander verbunden sind, dadurch gekennzeichnet, daß die Kontakte (2a und 2b) abwechselnd und in einer Kopf-Fuß-Anordnung angeordnet sind und daß die Klemme jedes Kontaktes lediglich zwei Lamellen (3 und 4) aufweist, wobei die Lamelle (3) gefaltet ist, während die Lamelle (4) eben ist und an die Randleiste (5a oder 5b) angrenzt.

2. Baueinheit aus Kontakten nach Anspruch 1, dadurch gekennzeichnet, daß zwischen dem Ende der Klemme und der benachbarten Handleiste (5a oder 5b) eine Sollbruch-Stelle (7) vorgesehen ist.

3. Verfahren zur Anordnung von Kontakten auf Substraten mittels der Baueinheit aus Kontakten nach Anspruch 1 oder 2, dadurch gekennzeichnet, daß man von jeder Handleiste (5a oder 5b) die ebenen Lamellen (4), die an sie angrenzen abtrennt, derart, daß zwei Unter-Baueinheiten von Kontakten gebildet werden, von denen jeder an seinem freien Ende eine Klemme trägt, daß man diese beiden Unter-Baueinheiten voneinander entfernt, um sie in verschiedene Ebenen zu führen, daß man gleichzeitig Substrate in die Klemmen der Kontakte der beiden Unter-Baueinheiten einführt und daß man von den Kontakten mit eingeführtem Substrat die Handleiste (5a oder 5b) entfernt.

**Claims**

1. An assembly of contacts to be welded having a clip at one of their ends formed by a band (1) in which the contacts (2a and 2b) are formed and connected together by strips (5a and 5b), characterized in that the contacts (2a and 2b) are alternated and disposed head to tail and in that the clip of each contact comprises only two legs (3 and 4), the leg (3) being bent whereas the leg (4) is flat and attached to the strip (5a or 5b).

2. The contact assembly according to claim 1, characterized in that a break line (7) is provided between the end of the clip and the adjacent strip (5a or 5b).

3. A method positioning contacts on substrates using the contact assembly according to claim 1 or 2, characterized in that the flat legs (4) which are attached to each strip (5a or 5b) are separated therefrom so as to form two contact subassemblies each comprising a clip at its free end, in that these two subassemblies are spaced apart so as to bring them into different planes, in that substrates are simultaneously inserted in the clips of the contacts of the two sub-assemblies and the strip (5a or 5b) is removed from the inserted contacts.

FIG. 1

FIG. 2

0 072 727